Europäisches Patentamt

European Patent Office

Office européen des brevets

(19)

(11) Veröffentlichungsnummer : **0 092 104**
**B1**

(12) **EUROPÄISCHE PATENTSCHRIFT**

(45) Veröffentlichungstag der Patentschrift :
28.08.85

(21) Anmeldenummer : 83103337.8

(22) Anmeldetag : 06.04.83

(51) Int. Cl.⁴ : **H 05 K   7/14, A 47 B 88/12**

(54) Gestell mit mittels Seitengleitführungen verstellbaren Kartenrahmen.

(30) Priorität : 21.04.82 GB 8211566

(43) Veröffentlichungstag der Anmeldung :
26.10.83 Patentblatt 83/43

(45) Bekanntmachung des Hinweises auf die Patenterteilung : 28.08.85 Patentblatt 85/35

(84) Benannte Vertragsstaaten :
AT BE CH DE FR GB IT LI NL SE

(56) Entgegenhaltungen :
EP-A- 0 041 616
CH-A-   543 259
US-A- 2 606 091
US-A- 2 809 085
US-E-   25 243
WESTERN ELECTRIC TECHNICAL DIGEST, Nr. 13,
Januar 1969, Seiten 31-32, New York, USA C. MUEL-
LER:"Slide and lacing strip for telephone exchange
framework"

(73) Patentinhaber : **Rittal-Werk Rudolf Loh GmbH & Co.
KG
Auf dem Stützelberg
D-6348 Herborn (DE)**

(72) Erfinder : **Erlam, David Paul
"Spindlewood" Partridge Down Oliver's Battery
Winchester Hampshire (GB)**
Erfinder : **Carr, Arthur Edgar
Chanson Highfield Avenue Twyford
Winchester Hampshire (GB)**

(74) Vertreter : **Vogel, Georg
Hermann-Essig-Strasse 35 Postfach 105
D-7141 Schwieberdingen (DE)**

**Beschreibung**

Die Erfindung betrifft ein Gestell mit zwei vorderen und zwei hinteren vertikalen Befestigungswinkeln, an denen pro Kartenrahmen jeweils zwei aufeinander ausgerichtete Seitengleitführungen zur verstellbaren Befestigung von mit Seitenplatten versehenen Kartenrahmen angebracht sind.

Bei einem bekannten Gestell dieser Art, siehe z. B. « Western Electric Technical Digest », Nr 13, Januar 1969, Seiten 31-32, C. MUELLER : « Slide and lacing strip for telephone exchange framework », sind die Seitengleitführungen als dreiteilige Teleskopführungen ausgebildet, bei denen die Auszugsendstellung mittels Rastfedern festgelegt wird. Vor dem Einschieben des an den am weitesten ausziehbaren Teilen der Teleskopführungen angebrachten Gerätes müssen die Rastfedern manuell entriegelt werden. Ein Lösen des Gerätes von den Teleskopführungen erfordert eine aufwendige Montagearbeit.

Für die ausziehbare Befestigung von Kartenrahmen in Gestellen sind zwei besonders wichtige Gesichtspunkte bei der Auslegung der Seitengleitführungen zu beachten. Da die Gestelle im allgemeinen stets eine Standardgröße aufweisen und die verschiedenen Standardentwicklungen von Kartenrahmen einen eng benachbarten Einbau in diese Gestelle vorsieht, steht nur ein begrenzter Platz zur Verfügung. Da die Kartenrahmen in der Entwicklung so konzipiert sind, daß sie vom Anwender (kleine Elektronik-Hersteller) zusammengebaut und eingebaut werden können, und da der Anwender keine speziellen Möglichkeiten (z. B. der Metallbearbeitung) und Werkzeuge hat, sollten die Seitenleitführungen so ausgelegt sein, daß sie mit einfachen Werkzeugen von jedem Nichtfachmann zusammengebaut werden können. Die bekannten Seitengleitführungen erfüllen für diese Aufgabe die gestellten Bedingungen nicht. Sie sind in der Regel selbst von erfahrenem Einbaupersonal viel zu schwierig zu montieren und erfordern einen bestimmten Anteil an Matallbearbeitung an dem Gestell und/oder dem Kartenrahmen.

Es ist Aufgabe der Erfindung, für ein Gestell der eingangs erwähnten Art einfache und leicht montierbare Seitengleitführungen zu schaffen, die einen lösbaren, verstellbaren Einbau der Kartenrahmen in ein mit Öffnung versehenes Gestell ermöglicht.

Diese Aufgabe wird nach der Erfindung dadurch gelöst, daß jede Seitengleitführung einen Träger aufweist, dessen Enden in Aufnahmen von zwei Profilleistenabschnitten eingesteckt sind, die an dem zugeordneten vorderen und hinteren Befestigungswinkel des Gestelles befestigt sind, daß auf den Trägern Schlitten verstellbar sind, die auf ihren einander zugekehrten Innenseiten von dieser jeweils am vorderen Ende unten einen Absatz mit einer Trägerplatte und am hinteren Ende oben eine Verlängerung aufweisen, daß an jeder Seitenplatte des Kartenrahmens ein nach hinten abstehender Ausleger angebracht ist, der jeweils im Bereich der Oberkante seines freien Endes mit einer Aufnahme zum Eingriff der Verlängerung einer der Schlitten versehen ist und daß die Ausleger in Schrägstellung auf den Trägerplatten abgestützt einschiebbar und durch Absenken des Kartenrahmens und Eingriff der Verlängerungen in die Aufnahmen an den Schlitten horizontal und axial unverschiebbar festlegbar sind.

Der Kartenrahmen kann bei dieser Ausgestaltung leicht von den Schlitten der Seitengleitführungen gelöst und wieder mit diesen verbunden werden. Dabei ist die lösbare Wirkverbindung zwischen den Auslegern des Kartenrahmens und den Schlitten so, daß sie bei der normalen Verstellbewegung des Kartenrahmens nicht unbeabsichtigt ganz oder teilweise aufgehoben wird. Der Einbau der Seitengleitführungen in das Gestell und die Anbringung der Ausleger an die Seitenplatten des Kartenrahmens erfordert nur einfache Werkzeuge, aber keine zusätzliche Metallbearbeitung beim Einbau.

Die Anbringung der Profilleistenabschnitte zur Aufnahme der Enden der Träger an den Befestigungswinkeln ist nach einer Ausgestaltung so, daß die Profilleistenabschnitte zwei zylinderförmige Ausformungen aufweisen, deren Abstand einem ganzzahligen Vielfachen der Teilung einer Reihe von Durchbrüchen in den nach innen im Winkel von 90° abgewinkelten Befestigungsschenkeln der Befestigungswinkel entspricht. Die Ausrichtung der Befestigungsschrauben auf die Ausformungen in den Profilleistenabschnitten wird nach einer Ausgestaltung dadurch erreicht, daß die Durchbrüche in den Befestigungsschenkeln der Befestigungswinkel rechteckförmig oder quadratisch ausgebildet sind und daß in die Durchbrüche ausrichtelemente mit einer Durchgangsbohrung für die Befestigungsschrauben eingesetzt sind, die unverdrehbar in den Durchbrüchen gehalten sind und den Profilleistenabschnitten zugekehrt nicht aus den Durchbrüchen ragen.

Die Ausgestaltung der Schlitten ist nach einer Ausführungsform so vorgenommen, daß die Schlitten C-förmig gestaltet sind und eine auf den Querschnitt der Träger abgestimmte Aufnahme bilden, daß die Ansätze und die Verlängerungen als L-förmige, gegeneinander gerichtete Stege ausgebildet sind, daß die Aufnahmen in den Auslegern als nutartige Ausstanzungen gestaltet sind, die auf die Breite der Verlängerungen ausgelegt sind und daß der Abstand der Tragfläche des Ansatzes von dem horizontalen Schenkel der Verlängerung der Breite der Ausleger im Bereich des Nutgrundes der Aufnahmen entspricht.

Die Stabilität der Ausleger wird nach einer Ausgestaltung dadurch erhöht, daß die Ausleger an ihren Längskanten abgekantet sind.

Das Einführen der Ausleger in die durch die Ansätze und Verlängerungen der Schlitten gebildeten Aufnahmen wird dadurch erleichtert, daß der Abstand der vertikalen Schenkel des Ansatzes und der Verlängerung von der zugekehrten Wand des Schlittens größer ist als die maximale Dicke der Ausleger. Die Ausleger haben an den Schlitten ein ausreichend großes seitliches Spiel.

Eine platzsparende Verbindung zwischen den Auslegern und den Seitenplatten des Kartenrahmens wird nach einer Ausgestaltung dadurch erreicht, daß die Seitenplatten des Kartenrahmens auf den einander zugekehrten Innenseiten flache Kanäle aufweisen, in denen die Ausleger befestigt sind und daß die in den Kanälen befestigten Ausleger nicht über die an-grenzenden Innenseiten der Seitenplatten vorste-hen.

Um verschiedene Auszugswege für den Kartenrahmen zu erhalten, sieht eine weitere Ausgestaltung vor, daß die Ausleger in verschiedenen Stellungen mit den Seitenplatten des Kartenrahmens verbindbar sind.

Damit die Kartenrahmen in der Einschubendstellung gesichert werden können, sieht eine Weiterbildung vor, daß an den Vorderkanten der Seitenplatten des Kartenrahmens Befestigungsflansche mit Befestigungsbohrungen angeformt, sind, daß die Befestigungsbohrungen einen Abstand aufweisen, der dem Abstand von weiteren zylindrischen Ausformungen der Profilleistenabschnitte entspricht und daß dieser Abstand einem ganzzahligen Vielfachen der Teilung der in den Befestigungsschenkeln der Befestigungswinkel eingebrachten Reihe von Durchbrüchen entspricht.

Ist nach einer weiteren Ausgestaltung vorgesehen, daß auf die vorderen Enden der Träger aus Draht oder dgl. gebogene Federn aufgesteckt sind, die in die Aufnahme des zugeordneten Profilleistenabschnittes eingesteckt ist und sich über einen Teil der Länge des Endes des Trägers erstreckt und daß die Feder den Schlitten in der Auszugsendstellung klemmend festhält, dann wird auch die Auszugsendstellung mit einer vorgegebenen Kraft festgehalten.

Die Erfindung wird anhand eines in den Zeich-nungen dargestellten Ausführungsbeispeils nä-her erläutert. Es zeigt :

Figur 1 eine perspektivische Vorderansicht eines Kartenrahmens,

Figur 2 eine perspektivische Vorderansicht einer Seitenplatte des Kartenrahmens nach Fig. 1 mit daran festgelegtem Ausleger,

Figuren 3A und 3B eine perspektivische Explosionsdarstellung der zusammengehörenden Teile einer Seitengleitführung zum Einbau des Kartenrahmens in ein Gestell,

Figur 4 einen vergrößerten Schnitt durch ein Ausrichtelement entlang der Linie IV-IV der Fig 3A, der das in einen Durchbruch eines Front-befestigungswinkels des Gestelles eingesetzte Aus-richtelement erkennen läßt und

Figur 5 eine vergrößerte perspektivische Vorderansicht eines in Fig. 3B verwendeten Schlittens.

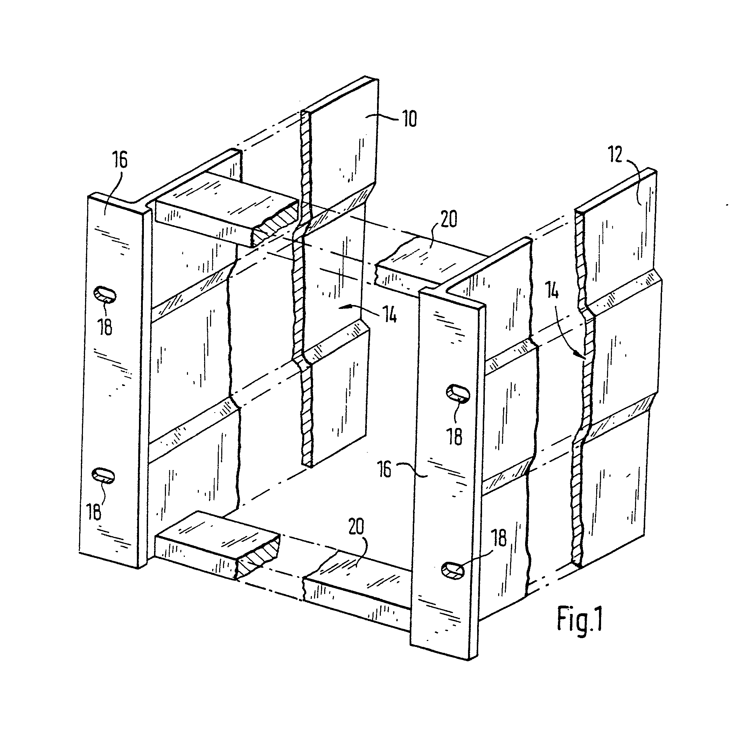

Fig. 1 ist eine perspektivische Vorderansicht eines Kartenrahmens, der aus einer linken, im Druckgußverfahren hergestellten Seitenplatte 10 aus Metall und einer rechten, im Druckgußverfahren hergestellten Seitenplatte 12 aus Metall besteht. Die Seitenplatten 10 und 12 sind vorzugsweise, aber nicht zwingend, identisch ausgebildet. Jede dieser Seitenplatten 10 und 12 ist so ausgebildet, daß sie einen einstückig geformten flachen Kanal 14 aufweist, der sich auf der Innenseite vom vorderen bis zum hinteren Ende erstreckt. Außerdem hat jede Seitenplatte einen Frontbefestigungsflansch 16, der einstückig an der Seitenplatte angeformt ist. Die Frontbefestigungsflansche 16 haben Löcher 18, um den Kartenrahmen in einem Gestell, wie später noch beschrieben wird, zu befestigen.

Die Seitenplatten 10 und 12 sind in zueinander vertikalen Ebenen angeordnet und miteinander verbunden und zwar mittels einer Vielzahl von horizontal ausgerichteten Querstreben 20, von denen in Fig. 1 zwei gezeigt sind. Die Querstreben 20 sind mittels geeigneter, nicht dargestellter Mittel mit den Seitenplatten 10 und 12 verbunden. Die gezeigten und andere Querstreben 20 dienen zur Anbringung von anderen Bauteilen des Kartenrahmens, wie Kartenfüllungen zur Aufnahme der Karten und elektrische Verbinder zur Verbindung mit Karten, die in die Kartenführungen eingeführt sind. Der in Fig. 1 gezeigte Kartenrahmen kann z. B. dieselbe Form aufweisen, wie sie in der EP-A-0 068 850 beschrieben ist.

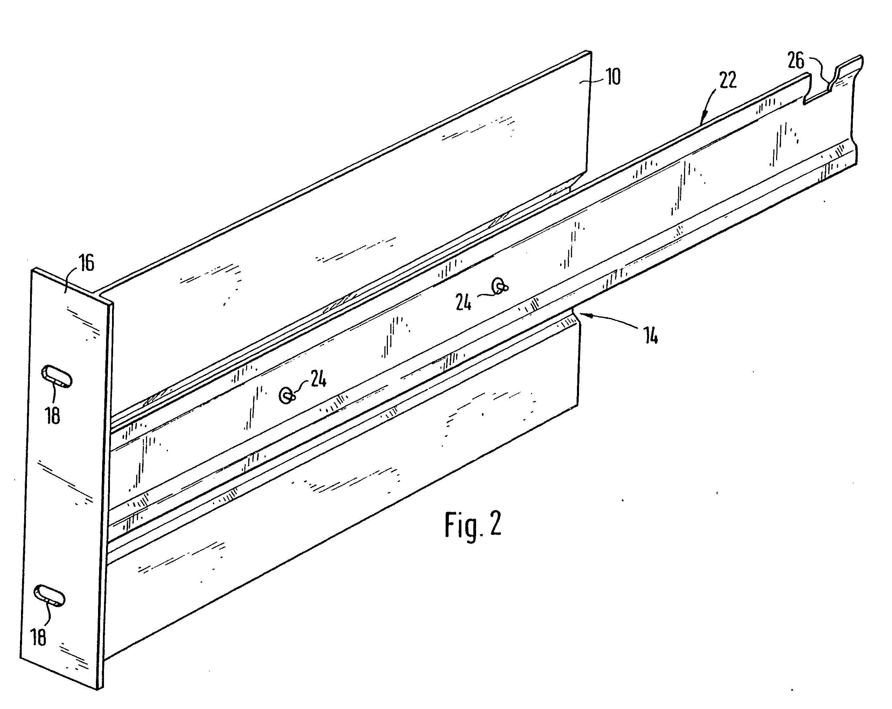

Eine Seitengleitführung, die den Kartenrahmen nach Fig. 1 lösbar und verstellbar mit einem Gestell verbindet, wird nun anhand der Fig. 2 bis 5 beschrieben.

Wie Fig. 2 zeigt, wird ein Ausleger 22 mittels Schrauben 24 oder dgl. in dem Kanal 14 auf der Innenseite der linken Seitenplatte 10 befestigt. Die Seitenplatte 10 weist dazu eingeformte Löcher auf. Der Ausleger 22 ist aus einem Stahlblech geformt und ist entlang seiner Längskanten abgekantet, um seine Stabilität zu erhöhen. Aufgrund des Kanals 14 ragt die innere Oberfläche des Auslegers 22 nicht über die Ebene hinaus, die durch die über und unter dem Kanal 14 angeordneten Innenseiten der Seitenplatte 10 bestimmt wird. Diese Ausgestaltung bringt eine optimale Raumausnützung, obwohl (mit schlechterer Raumausnützung) der Ausleger 22 auch auf der Außenseite der Seitenplatte 10 oder auf der Innenoder Außenseite einer anderen Form von Seitenplatte ohne einen Kanal 14 befestigt werden könnte. Wie der Fig. 2 weiter zu entnehmen ist, erstreckt sich der Ausleger 22 etwas über das hintere Ende der Seitenplatte 10 hinaus und weist am freien Ende der Oberkante eine Aufnahme oder einen Ausschnitt 26 auf.

Ein ähnlicher Ausleger ist in dem Kanal 14 auf der Innenseite der rechten Seitenplatte 12 befestigt. Da dieser Ausleger und seine Befestigung im wesentlichen dem gezeigten Ausleger 22 entsprechen, wird dieser Ausleger nicht in Einzelheiten beschrieben.

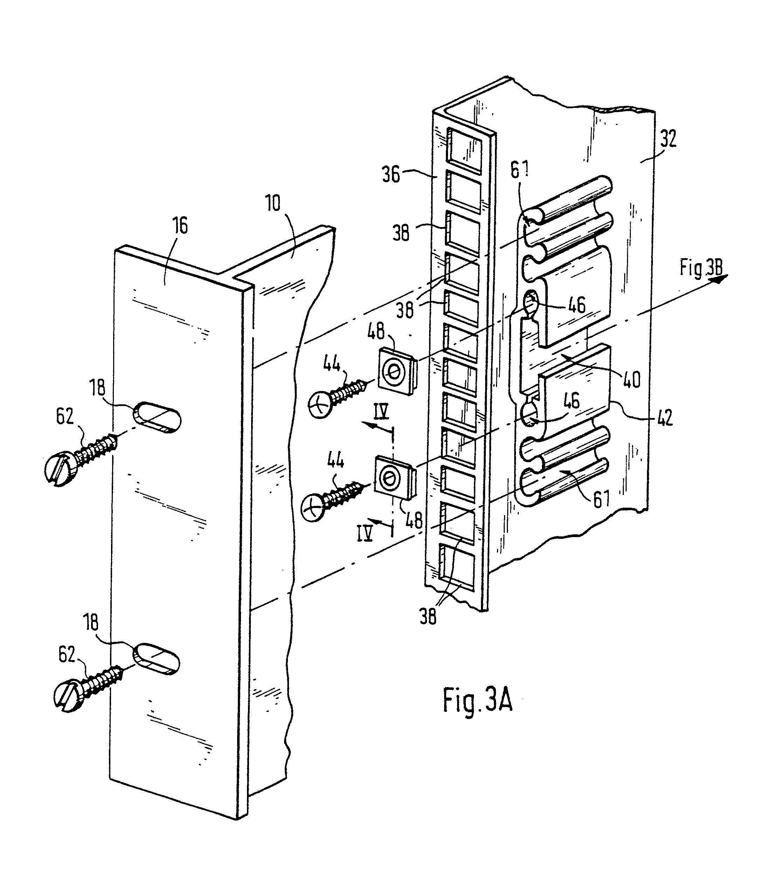

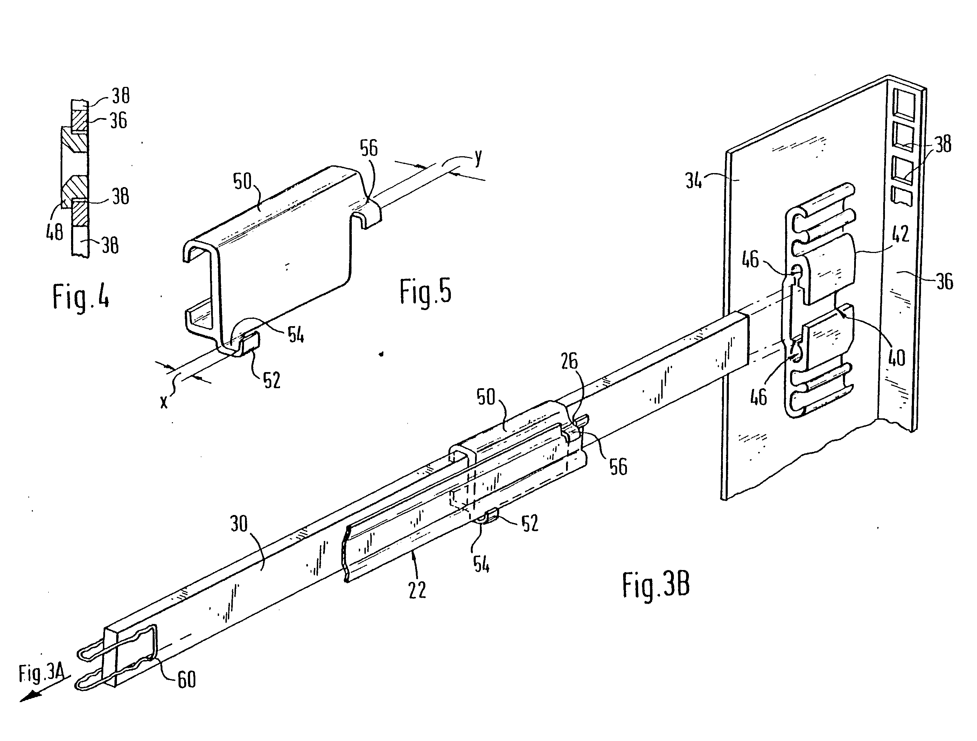

Die Seitengleitführung enthält außerdem ein Paar Stahlträger, die auf der Innenseite der einander gegenüberliegenden Schenkel der Befestigungswinkel des Gestelles angebracht sind und sich von dem vorderen zum hinteren Ende der Seitenteile des Gestelles erstrecken. Ein solcher Träger, der zur Verbindung mit dem in Fig. 2 dargestellten Ausleger 22 ausgebildet ist, ist in Fig. 3B mit dem Bezugszeichen 30 gekennzeichnet. Die Art seiner Befestigung wird anhand der Fig. 3A und 3B näher beschrieben. Der andere Träger wird in gleicher Weise mit dem anderen Ausleger verbunden.

Das Gestell ist eine Standardkonstruktion und hat an der Vorder- und Rückseite Befestigugswinkel 32 und 34, die jeweils einen im Winkel von 90° nach innen gerichteten Befestigungsschenkel 36 mit einer Reihe von rechtwinkligen (quadratischen oder rechteckigen) Durchbrüchen 38 aufweisen. Die Durchbrüche 38 sind in einem Standardabstand abgeordnet. Jedes Ende des Trägers 30 wird in der Aufnahme 40 eines Profilleistenabschnittes 42 festgelegt. Die Profilleistenabschnitte 42 werden aufeinander ausgerichtet an den Innenseiten der Befestigngsschenkel 36 der Befestigungswinkel 32 und 34 befestigt. Die Schrauben 44 werden durch zugeordnete Durchbrüche 38 hindurchgeführt, über die Ausrichtelemente 48 ausgerichtet (Fig. 3A und Fig. 4) und in zylinderförmige Ausformungen 46 der Profilleistenabschnitte 42 eingeschraubt.

Die Ausrichtelemente 48 sind in ihrer Ausgestaltung auf die Durchbrüche 38 abgestimmt und so darin gehalten, daß sie nicht über die hinteren Enden der Durchbrüche vorstehen. Die Ausrichtelemente 48 wandeln daher die zugeordneten rechteckförmigen Durchbrüche 38 in Durchgangsbohrungen für die Schrauben 44 um. Die runden Ausformungen der Ausrichtelemente 48 können mit Gewinde versehen sein, sie sind jedoch vorzugsweise gewindelos, da selbstschneidende Schrauben 44 verwendet werden.

Ein Schlitten 50 (Fig 3B und Fig. 5), der vorzugsweise ein bearbeiteter Profilleistenabschnitt oder ein Metallgußteil sein kann, ist auf dem Träger 30 verstellbar, wie Fig. 3B zeigt. (Ein ähnlicher Schlitten ist auf dem anderen Träger in ähnlicher Weise verstellbar). Ein Ansatz 52, der am vorderen Ende im Bodenbereich des Schlittens 50 angebracht ist, bildet eine Abstützfläche 54. Der Schlitten 50 ist am hinteren Ende der Oberkante mit einer Verlängerung 56 versehen.

Eine gebogene Feder 60 (Fig. 3B) aus Draht oder dgl. wird auf das vordere Ende des Trägers 30 aufgesteckt, bevor dieses Ende des Trägers in die Aufnahme 40 des vorderen Profilleistenabschnittes 42 eingeführt wird, wobei nach dem Zusammenbau ein Teil der Feder 60 sich aus der Aufnahme 40 heraus am vorderen Ende über einen kleinen Teil der Länge des Trägers 30 erstreckt. Eine ähnliche Feder (nicht dargestellt) ist am vorderen Ende des anderen Trägers angebracht.

Der Kartenrahmen wird in folgender Weise in das Gestell eingebaut : Zuerst wird der Schlitten 50 in Richtung zur Vorderseite des Gestelles verschoben. Die Federn 60 werden in die Schlitten 50 eingedrückt, wenn diese die Vorderseite des Gestelles erreichen und üben eine Kraft aus, die die Schlitten daran hindert, in Richtung zur Rückseite des Gestelles verschoben zu werden. Diese Kraft kann jedoch durch ausreichenden Druck aufgehoben werden, wenn der Kartenrahmen mit den Schlitten verbunden ist. Der Kartenrahmen wird so gehalten, daß die Vorderseite nach oben angehoben ist und die nach rückwärts gerichteten Teile der Ausleger 22 etwas schräg zu den Trägern 30 stehen. Die unteren Enden der Ausleger 22 werden dann mit den Trägerflächen 54 in Wirkverbindung gebracht und auf diesen ein wenig in das Gestell eingeschoben. Der Kartenrahmen wird dann abgesenkt, wobei die Ausleger 22 sich um die Trägerflächen 54 drehen. Der Kartenrahmen wird so verschoben, bis die Verlängerungen 56 (Fig. 3B) in die Aufnahmen 26 eingreifen. Der Kartenrahmen wird dann freigegeben und sein Gewicht wird von den Trägerflächen 54 und den Verlängerungen 56 getragen. Der Kartenrahmen kann dann in das Gestell eingeschoben werden, wobei die Wirkverbindung zwischen den Verlängerungen 56 und den Aufnahmen 26 eine relative Verstellung der Ausleger 22 und der Schlitten 50 auf den Trägern 30 verhindert. Der Kartenrahmen wird mit den Schlitten 50 verstellt. Es ist auch einzusehen, daß diese in Wirkverbindung miteinander stehenden Verlängerungen 56 und Aufnahmen 26 eine Trennung von Kartenrahmen und Schlitten verhindern, wenn der Kartenrahmen in das Gestell eingeschoben und aus dem Gestell herausgezogen wird. Um den Kartenrahmen zu lösen, ist es erforderlich, den Kartenrahmen aus dem Gestell herauszuziehen und anzuheben, um die Verlängerungen 56 und die Aufnahmen 26 außer Wirkverbindung zu bringen. Dann kann der Kartenrahmen in der nach aufwärts geneigten Stellung herausgezogen werden.

Die Breiten der Trägerflächen 54 und Verlängerungen 56 (die Abmessungen x und y in Fig. 5) jedes Schlittens sind vorzugsweise beträchtlich größer als die Dicke der Ausleger 22. Dadurch wird eine seitliche Toleranz geschaffen, die die Leichtigkeit, mit der die Ausleger 22 mit den Schlitten 50 in Wirkverbindung miteinander gebracht werden können, wesentlich erhöht.

Die Extruderabschnitte 42 sind mit weiteren zylindrischen Ausformungen versehen. Zwei dieser weiteren zylindrischen Ausformungen in den vorderen Extruderabschnitten 42 sind in Fig. 3A mit 61 gekennzeichnet. Diese Ausformungen 61 können anstelle von normalerweise verwendeten Käfigmuttern zur Aufnahme von Schrauben 62 verwendet werden, die durch die Löcher 18 in den Frontbefestigungsflanschen 16 eingeführt sind, um den Kartenrahmen in dem Gestell festlegen zu können. Wenn bei einigen Gestellen mit größerer Tiefe in den Befestigungsflanschen 16 weitere Befestigungslöcher vorgesehen sind, dann können die Schrauben durch diese Befestigungslöcher hindurch in Käfigmuttern eingeschraubt werden, die in bekannter Weise in anderen Durchbrüchen 38 festgelegt sind.

Die beschriebene Seitengleitführung ist leicht einzubauen, da der Einbau keinerlei Bohrarbeiten oder andere Metallbearbeitungsvorgänge erfordert. Die Ausleger 22 können mit den Seitenplatten 10 und 12 über die Löcher verbunden werden, die schon bei der Herstellung Seitenplatten im Gießverfahren eingebracht worden sind. Auch die Befestigung der Träger 30 im Gestell ist sehr einfach, da sie nur die Bedienung eines Schraubendrehers von der Außenseite des Gestelles aus erfordert. Außerdem ist die Festlegung des Kartenrahmens an den Schlitten eine Angelegenheit von beachtlicher Einfachheit, wie aus der vorhergehenden Beschreibung ersichtlich ist.

Die Einrichtung hat zudem weitere Vorteile. Obgleich die Ausleger 22 so gestaltet sind, daß sie für eine bestimmte Ausgestaltung des Kartenrahmens mit Seitenplatten 10 und 12 und innenliegenden Kanälen 14 vorgesehen sind, können sie auch mit anders gestalteten Kartenrahmen und Untergestellen verbunden werden. Dabei kann es erforderlich sein, in den Seitenplatten zusätzlich Bohrungen einzubringen. Ein weiterer Vorteil liegt darin, daß die einzige Änderung zum Einsatz der Einrichtung für Gestelle mit verschiedener Tiefe die Anpassung der Länge der Träger ist. Werden verschieden lange Träger zur Verfügung gestellt, dann kann der Verwender Seitengleitführungen für verschiedene Gestelltiefen zusammenstellen. Es ist außerdem möglich, eine Seitengleitführung für eine nicht standardisierte Gestelltiefe zu erstellen, in dem die nächst größere Länge der Träger gewählt wird und diese auf die richtige Länge abgeschnitten werden. Sieht man mehrere Befestigungslöcher in den Seitenplatten 10 und 12 zum Anbringen der Ausleger 22 vor, dann können die Ausleger 22 so verstellt werden, daß sie weiter über die Rückseite des Kartenrahmens vorstehen. Damit kann der Kartenrahmen weiter aus dem Gestell herausgezogen werden.

Die Seitengleitführung, wie sie anhand der Zeichnungen beschrieben wurde, ist besonders für eine lösbare Gleitbefestigung eines Kartenrahmens in einem Gestell entwickelt. Die Erfindung ist jedoch allgemeiner einsetzbar. Die Einrichtung kann so abgewandelt werden, daß sie andere Gegenstände in einem Gestell, Kartenrahmen in anderen Gehäusen oder andere Gegenstände in anderen Gehäusen befestigt.

**Patentansprüche**

1. Gestell mit zwei vorderen und zwei hinteren vertikalen Befestigungswinkeln, an denen pro Kartenrahmen jeweils zwei aufeinander ausgerichtete Seitengleitführungen zur verstellbaren Befestigung von mit Seitenplatten versehenen Kartenrahmen angebracht sind, dadurch gekennzeichnet, daß jede Seitengleitführung einen Träger (30) aufweist, dessen Enden in Aufnahmen (40) von zwei Profilleistenabschnitten (42) eingesteckt sind, die an dem zugeordneten vorderen und hinteren Befestigungswinkel (32, 34) des Gestelles befestigt sind, daß auf den Trägern (30) Schlitten (50) verstellbar sind, die auf ihren einander zugekehrten Innenseiten von dieser jeweils am vorderen Ende unten einen Ansatz (52) mit einer Trägerplatte (54) und am hinteren Ende oben eine Verlängerung (56) aufweisen, daß an jeder Seitenplatte (10, 12) des Kartenrahmens ein nach hinten abstehender Ausleger (22) angebracht ist, der jeweils im Bereich der Oberkante seines freien Endes mit einer Aufnahme (26) zum Eingriff der Verlängerung (56) einer der Schlitten (50) versehen ist und daß die Ausleger (22) in Schrägstellung auf den Trägerplatten (54) abgestützt einschiebbar und durch Absenken des Kartenrahmens und Eingriff der Verlängerungen (56) in die Aufnahmen (26) an den Schlitten (50) horizontal und axial unverschiebbar festlegbar sind.

2. Gestell nach Anspruch 1, dadurch gekennzeichnet, daß die Profilleistenabschnitte (42) zwei zylinderförmige Ausformungen (46) aufweisen, deren Abstand einem ganzzahligen Vielfachen der Teilung einer Reihe von Durchbrüchen (38) in den nach innen im Winkel von 90° abgewinkelten Befestigungsschenkeln (36) der Befestigungswinkel (32, 34) entspricht.

3. Gestell nach Anspruch 2, dadurch gekennzeichnet, daß die Durchbrüche (38) in den Befestigungsschenkeln (36) der Befestigungswinkel (32, 34) rechteckförmig oder quadratisch ausgebildet sind und daß in die Durchbrüche (38) Ausrichtelemente (48) mit einer Durchgangsbohrung für die Befestigungsschrauben (44) eingesetzt sind, die unverdrehbar in den Durchbrüchen (38) gehalten sind und den Profilleistenabschnitten (42) zugekehrt nicht aus den Durchbrüchen (38) ragen.

4. Gestell nach einem der Ansprüche 1 bis 3, dadurch gekennzeichnet, daß die Schlitten (50) C-förmig gestaltet sind und eine auf den Querschnitt der Träger (30) abgestimmte Aufnahme bilden, daß die Ansätze (52) und die Verlängerungen (56) als L-förmige, gegeneinander gerichtete Stege ausgebildet sind, daß die Aufnahmen (26) in den Auslegern (22) als nutartige Austanzungen gestaltet sind, die auf die Breite der Verlängerungen (56) ausgelegt sind und daß der Abstand der Tragfläche (54) des Ansatzes (52) von dem horizontalen Schenkel der Verlängerung (56) der Breite der Ausleger (22) im Bereich des Nutgrundes der Aufnahmen (26) entspricht.

5. Gestell nach einem der Ansprüche 1 bis 4, dadurch gekennzeichnet, daß die Ausleger (22) an ihren Längskanten abgekantet sind.

6. Gestell nach einem der Ansprüche 1 bis 5, dadurch gekennzeichnet, daß der Abstand der vertikalen Schenkel des Ansatzes (52) und der Verlängerung (56) von der zugekehrten Wand des Schlittens (50) größer ist als die maximale Dicke der Ausleger (22).

7. Gestell nach einem der Ansprüche 1 bis 6, dadurch gekennzeichnet, daß die Seitenplatten (10, 12) des Kartenrahmens auf den einander zugekehrten Innenseiten flache Kanäle (14) aufweisen, in denen die Ausleger (22) befestigt sind.

8. Gestell nach Anspruch 7, dadurch gekennzeichnet, daß die in den Kanälen (14) befestigten Ausleger (22) nicht über die angrenzenden Innenseiten der Seitenplatten (10, 12) vorstehen.

9. Gestell nach Anspruch 7 oder 8, dadurch gekennzeichnet, daß die Ausleger (22) in verschiedenen Stellungen mit den Seitenplatten (10, 12) des Kartenrahmens verbindbar sind.

10. Gestell nach einem der Ansprüche 1 bis 9, dadurch gekennzeichnet, daß an den Vorderkanten der Seitenplatten (10, 12) des Kartenrahmens Befestigungsflansche (16) mit Befestigungsbohrungen (18) angeformt sind, daß die Befestigungsbohrungen (18) einen Abstand aufweisen, der dem Abstand von weiteren zylindrischen Ausformungen (61) der Profilleistenabschnitte (42) entspricht und daß dieser Abstand einem ganzzahligen Vielfachen der Teilung der in den Befestigungsschenkeln (36) der Befestigungswinkel (32, 34) eingebrachten Reihe von Durchbrüchen (38) entspricht.

11. Gestell nach einem der Ansprüche 1 bis 10, dadurch gekennzeichnet, daß auf die vorderen Enden der Träger (30) aus Draht oder dgl. gebogene Federn (60) aufgesteckt sind, die in die Aufnahme (40) des zugeordneten Profilleistenabschnittes (42) eingesteckt ist und sich über einen Teil der Länge des Endes des Trägers (30) erstreckt und daß die Feder (60) den Schlitten (50) in der Auszugsendstellung klemmend festhält.

**Claims**

1. A rack comprising two front and two rear vertical fixing angle members on which there are mounted, for each card frame, two side slide guides which are aligned relative to each other, for displaceably fixing card frames which are provided with side plates, characterised in that each side slide guide has a carrier (30) whose ends are fitted into receiving means (40) in two shaped strip portions (42) which are fixed to the associated front and rear fixing angle members (32, 34) of the rack, displaceable on the carriers (30) are slides (50) which, on the mutually facing inward sides thereof, are respectively provided at the front end, at the underneath, with a lug (52) having a carrier plate (54) and at the rear end, on the top, with an extension portion (5,6), mounted to each side plate (10, 12) of the card frame is a rearwardly projecting arm (22) which is respectively provided in the region of the upper edge of its free end with a receiving means (26) for engagement of the extension portion (56) of one of the slides (50), and the arms (2) can be pushed in supported in an inclined position on the carrier plates (54) and, by downward movement of the card frame and engagement of the extension portions (56) into the receiving means (26), can be horizontally and axially immovably secured to the slides (50).

2. A rack according to claim 1, characterized in that the shaped strip portions (42) have two cylindrical openings (46) whose spacing corresponds to an integral multiple of the pitch of a row of apertures (38) in the fixing limb portions (36) of the fixing angle members (32, 34) said limb portions being bent inwardly at an angle of 90°.

3. A rack according to claim 2, characterized in that the apertures (38) in the fixing limb portions (36) of the fixing angle members (32, 34) are of a square or rectangular configuration, and alignment elements (48) having a through bore for the fixing screws (44) are fitted into the apertures (38), being held non-rotatably in the apertures (38) and not projecting out of the apertures (38), towards the shaped strip portions (42).

4. A rack according to one of claims 1 to 3, characterized in that the slides (50) are of a C-shaped configuration and form a receiving means which is matched to the cross-section of the carriers (30), the lugs (52) and the extension portions (56) are formed as L-shaped leg portions which are directed towards each other, the receiving means (26) in the arms (22) are formed as groove-like punched-out portions which are adapted to the width of the extension portions (56), and the spacing of the carrier surface (54) of the lug (52) from the horizontal limb portion of the extension portion (56) corresponds to the width of the arm (22) in the region of the bottom of the groove of the receiving means (26).

5. A rack according to one of claims 1 to 4 characterized in that the arms (22) have their longitudinal edges chamferred or canted.

6. A rack according to one of the claims 1 to 5, characterized in that the spacing of the vertical limb portions of the lug (52) and the extension portion (56) from the facing wall of the slide (50) is greater than the maximum thickness of the arms (22).

7. A rack according to one of claims 1 to 6, characterized in that the side plates (10, 12) of the card frame are provided on the mutually facing inward sides with shallow channels (14) in which the arms (22) are secured.

8. A rack according to claim 7, characterized in that the arms (22) which are secured in the channels (14) do not project beyond the adjoining inward sides of the side plates (10, 12).

9. A rack according to claim 7 or 8, characterized in that the arms (22) can be connected to the side plates (10, 12) of the card frame in various positions.

10. A rack according to one of claims 1 to 9, characterized in that fixing flanges (16) with fixing bores (18) are formed at the front edges of the side plates (10, 12) of the card frame, the fixing bores (18) are at a spacing which corresponds to the spacing of further cylindrical openings (61) in the shaped strip portions (42), and said spacing corresponds to an integral multiple of the pitch of the row of apertures (38) provided in the fixing limb portions (36) of the fixing angle members (32, 34).

11. A rack according to one of claims 1 to 10, characterized in that fitted on to the front ends of the carriers (30) are springs (60) which are bent from wire or the like, the spring being fitted into the receiving means (40) of the associated shaped strip portion (42) and extending over a part of the length of the end of the carrier (30), and the spring (60) clampingly holds the slide (50) in the extended limit position.

## Revendications

1. Châssis comprenant deux équerres de fixation verticales avant et deux équerres de fixation verticales arrières, auxquels sont prévus deux guides latéraux coulissants orientés l'un vers l'autre, servant à la fixation ajustable de cadres pour cartes équipées de plaques latérales, caractérisé en ce que chaque guide latéral coulissant comprend un rail-support (30) dont les extrémités sont fichées dans des logements (40) de deux rails profilés (42) qui sont fixés à l'équerre de fixation avant et arrière correspondant (32, 34) du châssis, que les rails-supports (30) portent des glissoirs (50) ajustables équipés sur les côtés inférieurs d'une languette avant inférieure (52) avec une plaque portante (54) et d'une languette supérieure arrière (56), que chaque plaque latérale (10, 12) du cadre de cartes porte un bras débordant à l'arrière (22) qui est équipé dans la zone de son bord supérieur de son extrémité libre d'un logement (26) permettant l'entrée en prise de l'allonge (56) des glissoirs (50) et que les bras (22) en leur position oblique peuvent être enfichés dans les plaques-supports (54) en se reposant sur les dernières et peuvent être fixés horizontalement et axialement sur les glissoirs de manière immuable par abaissement du cadre de cartes et par entrée en prise des allonges (56) avec les logements (26).

2. Châssis selon la revendication 1, caractérisé en ce que les rails profilés (42) sont munis de deux ouvertures cylindriques (46) dont la distance correspond à un multiple entier de l'écartement d'une rangée de trous (38) prévus dans le côté d'angle inférieur coudé de 90° des équerres de fixation (32, 34).

3. Châssis selon la revendication 2, caractérisé en ce que les trous (38) dans les côtés de l'angle (36) des équerres de fixation (32, 34) sont de forme rectangulaire ou carrée et que dans les trous (38) sont montés des éléments d'alignement (48) avec des perçages traversants pour des vis de fixation (44), fixées dans les trous de façon non orientable et ne débordant pas des trous (38) du côté des rails profilés (42).

4. Châssis selon une des revendications de 1 à 3, caractérisé en ce que les glissoirs (50) sont d'une forme en « C » et forment un logement adapté à la coupe transversale des rails-supports (30), que les languettes (52, 56) dans les bras (22) sont réalisées sous forme de « L » en tant que barrettes opposées que les logements (26) dans les bras (22) sont réalisés sous forme de perforations en « rainure » correspondant à la largeur des allonges (56) et que la distance entre la surface portante de la languette (52) et le côté horizontal de la languette (56) correspond à la largeur des bras (22) dans la zone du fond de rainure des logements (26).

5. Châssis selon une des revendications de 1 à 4, caractérisé en ce que les bords longitudinaux des bras (22) sont pliés.

6. Châssis selon une des revendications de 1 à 5, caractérisé en ce que la distance entre les côtés verticaux de la languette (52) et de la languette (56) et la paroi opposée du glissoir (50) est plus grande que l'épaisseur maximale des bras (22).

7. Châssis selon une des revendications de 1 à 6, caractérisé en ce que les côtés intérieurs opposés des plaques latérales (10, 12) du cadre de cartes sont munis de conduits peu profonds (14) dans lesquels les bras sont montés (22).

8. Châssis selon la revendication 7, caractérisé en ce que les bras (22) montés dans les conduits (14) ne débordent pas des côtés intérieurs avoisinants des plaques latérales (10, 12).

9. Châssis selon les revendications 7 ou 8, caractérisé en ce que les bras (22) sont reliables dans des positions différentes aux plaques latérales (10, 12) du cadre de cartes.

10. Châssis selon une des revendications de 1 à 9, caractérisé en ce que sur les bords avant des plaques latérales (10, 12) du cadre de cartes sont prévus des éléments de fixation (16) avec des perçages de fixation (18), que la distance entre les perçages de fixation (18) correspond à la distance des autres ouvertures cylindriques (61) dans les rails profilés (42) et que cette distance correspond à un multiple entier de l'écartement entre les trous d'une rangée (38) prévus dans les côtés d'angle de fixation (36) des équerres de fixation (32, 34).

11. Châssis selon une des revendications de 1 à 10, caractérisé en ce que des agrafes pliées (60) en fil de fer ou simil. sont montées sur les extrémités avant des rails-supports (30) qui sont enfichées dans le logement (40) du rail profilé correspondant (42) et s'étendent sur une partie de la longueur de l'extrémité du rail-support (30) et que l'agrafe (60) serre le glissoir (50) dans la position étendue finale.

Fig.1

Fig. 2

Fig.3A

Fig.4

Fig.5

Fig.3B

Fig.3A

0 092 104